# EUROPEAN PATENT SPECIFICATION

(11) **EP 3 013 035 B1**
(45) Date of publication and mention of the grant of the patent: **13.03.2019**
(21) Application number: 15190757.3
(22) Date of filing: 21.10.2015
(51) Int. Cl.: H04N 5/32, H04N 5/361, G01T 1/16, H01L 27/146, G01T 1/24, H04N 5/378, G01N 23/04

(54) **RADIATION DETECTION APPARATUS AND METHOD OF DRIVING THE SAME**
STRAHLUNGSDETEKTIONSVORRICHTUNG UND VERFAHREN ZUR ANSTEUERUNG DAVON
APPAREIL DE DETECTION DE RAYONNEMENT ET PROCEDE DE COMMANDE DE CE DERNIER

(30) Priority: 22.10.2014 KR 20140143599
(43) Date of publication of application: 27.04.2016
(73) Proprietor: Samsung Electronics Co., Ltd., Gyeonggi-do 16677 (KR)
(72) Inventor: LEE, Kang-ho, Gyeonggi-do (KR); KIM, Jin-myoung, Gyeonggi-do (KR); PARK, Jea-chul, Gyeonggi-do (KR)
(74) Representative: Grünecker Patent- und Rechtsanwälte PartG mbB

(56) References cited:
- WO-A1-2005/055591
- US-A1- 2001 007 586
- US-A1- 2002 179 868
- KASAP S O ET AL: "Direct-conversion flat-panel X-ray image detectors", IEE PROCEEDINGS: CIRCUITS DEVICES AND SYSTEMS, INSTITUTION OF ELECTRICAL ENGINEERS, STENVENAGE, GB, vol. 149, no. 2, 8 April 2002 (2002-04-08) , pages 85-96, XP006018071, ISSN: 1350-2409, DOI: 10.1049/IP-CDS:20020350
- Safa Kasap ET AL: "Amorphous and Polycrystalline Photoconductors for Direct Conversion Flat Panel X-Ray Image Sensors", Sensors, vol. 11, no. 12, 9 May 2011 (2011-05-09), pages 5112-5157, XP055321407, DOI: 10.3390/s110505112

## Description

### BACKGROUND

### 1. Field

Example embodiments relate to a radiation detection apparatus and/or a method of driving the same.

### 2. Description of the Related Art

Radiation, such as X-rays or gamma rays (γ-ray), has strong transmissivity, and thus, can be used to visualize the inside of an object. Therefore, radiation is generally used in medical areas and for nondestructive inspection. A radiation transmission amount changes with the density of the inside of an object, and the inside of the object is imaged by measuring a difference between radiation transmission amounts.

A photoconductor (i.e., an optical-to-electric conversion material) may be used for detecting the difference between radiation transmission amounts. When a photoconductor is irradiated, electron-hole pairs may be generated in the photoconductor, and thus, when an electric field is generated in the photoconductor, the electron-hole pairs may be separated into electrons and holes that may be converted into an electrical signal. An amount of electric charges generated in a photoconductor may change with an amount (intensity) of radiation passing through an object and reaching a photoconductor. Thus, the inside of the object may be imaged based on the difference between the amounts of electric charges generated.

US 2001/007586 A1 discloses a radiation detection apparatus with a driving method that includes applying a high voltage during a reset, irradiation and read-out period and turning off said voltage after the read-out until the next reset period starts.

US 2002/179868 A1 discloses a radiation detection apparatus where the turning off of said high voltage involves putting a switch at a midpoint and therefore turning the power supply in a floating state when voltage application to the detector is not carried out.

### SUMMARY

The main embodiments of the invention are defined by the appended independent claims. The appended dependent claims define further embodiments.

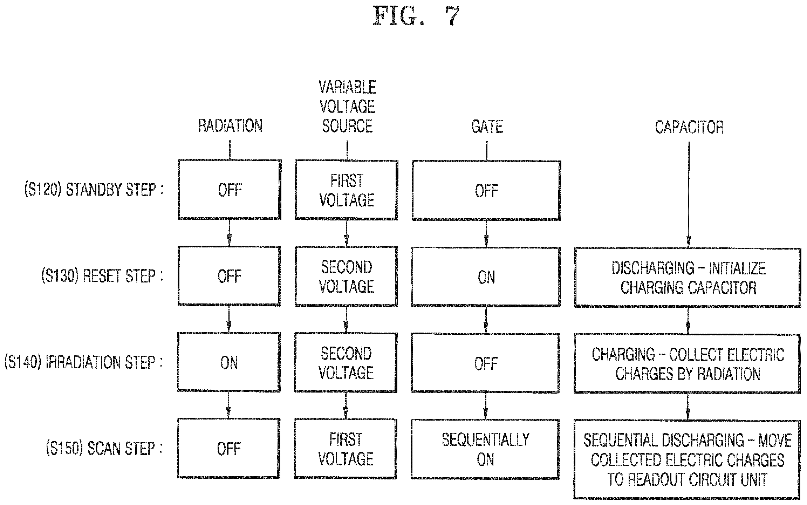

It is noted that the following "exemplary embodiments" in the description correspond to examples of the invention as filed. They do not necessarily correspond to embodiments as claimed in the patent granted. For an embodiment of the invention as claimed, the reader is referred to Fig. 7.

### BRIEF DESCRIPTION OF THE DRAWINGS

These and/or other aspects will become apparent and more readily appreciated from the following description of the example embodiments, taken in conjunction with the accompanying drawings in which:
FIG. 1 is a cross-sectional view illustrating a schematic structure of a radiation detection apparatus according to an example embodiment;
FIG. 2 is a flowchart for describing a method of driving a radiation detection apparatus according to an example embodiment;
FIGS. 3A to 3C are diagrams illustrating examples in which a voltage is applied to a counter electrode of a radiation detection apparatus in a standby step of the flowchart of FIG. 2;
FIG. 4 is a diagram for describing an operation in which a second voltage is applied to the counter electrode of the radiation detection apparatus, and when radiation is irradiated onto a photoconductor layer, a photocurrent is generated by the radiation, in an irradiation step of the flowchart of FIG. 2;
FIG. 5 is a schematic diagram illustrating a transistor and a charging capacitor, which are formed on an array substrate of a radiation detection apparatus according to an example embodiment, for one pixel;
FIG. 6 is a circuit diagram illustrating an example of a circuit configuration of a radiation detection apparatus according to an example embodiment;
FIG. 7 is a block diagram illustrating in detail driving of radiation, a variable voltage source, a gate, and a charging capacitor in each step of a method of driving a radiation detection apparatus according to an example embodiment;
FIG. 8 is a graph showing driving of radiation, an application voltage, and a gate with time in each step of a method of driving a radiation detection apparatus according to an example embodiment;
FIG. 9 is a graph showing a change in a capacitor voltage in each step of a method of driving a radiation detection apparatus according to an example embodiment;
FIG. 10 is a flowchart for describing a method of driving a radiation detection apparatus according to a comparative example;
FIGS. 11A and 11B are conceptual diagrams for describing an operation in which an electric charge caused by a dark current is detected along with an electric charge caused by radiation, in a method of driving a radiation detection apparatus according to a comparative example;
FIG. 12 is a graph showing driving of radiation, an application voltage, and a gate with time in each step of a method of driving a radiation detection apparatus according to a comparative example;
FIG. 13 is a graph showing a change in a capacitor voltage in each step of a method of driving a radiation detection apparatus according to an example embodiment; and
FIG. 14 is a block diagram illustrating a schematic configuration of a radiation imaging apparatus according to an example embodiment.

### DETAILED DESCRIPTION

Reference will now be made in detail to example embodiments, some examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects.

Hereinafter, example embodiments will be described in detail with reference to the accompanying drawings. The example embodiments should not be construed as being limited to the example embodiments set forth herein; rather, these embodiments are provided so that this disclosure will be thorough and complete, and will fully convey the example embodiments of the inventive concepts to those of ordinary skill in the art. In the drawings, like reference numerals refer to like elements, and the size and thickness of each element may be exaggerated for clarity and convenience of description.

It will be understood that although the terms "first", "second", etc. may be used herein to describe various components, these components should not be limited by these terms. These components are only used to distinguish one component from another.

Moreover, each of terms such as "...unit", "...apparatus" and "module" described in specification denotes an element for performing at least one function or operation, and may be implemented in hardware, software or the combination of hardware and software.

The expressions "about", "substantially", "equivalent", "more than", and "less than" described in association with a numerical value in the present specification should not be construed as matching a corresponding expression when the corresponding expression completely matches a described numerical value. The expressions are within a range which is commonly accepted by one of ordinary skill in the art, and for example, may include a range which is accepted by a relevant measurement error and a limitation of a measurement system.

The term "radiation image" used herein denotes an image of an object acquired by using radiation. Also, the term "object" used herein may include a person, an animal, a part of the person, or a part of the animal. For example, an object may include an organ such as a liver, a heart, a womb, a brain, breasts, an abdomen, or the like, or a blood vessel. Moreover, the term "user" used herein is a medical expert, and may be a doctor, a nurse, a medical technologist, a medical image expert, or the like, or may be an engineer who repairs a medical apparatus. However, the user is not limited thereto.

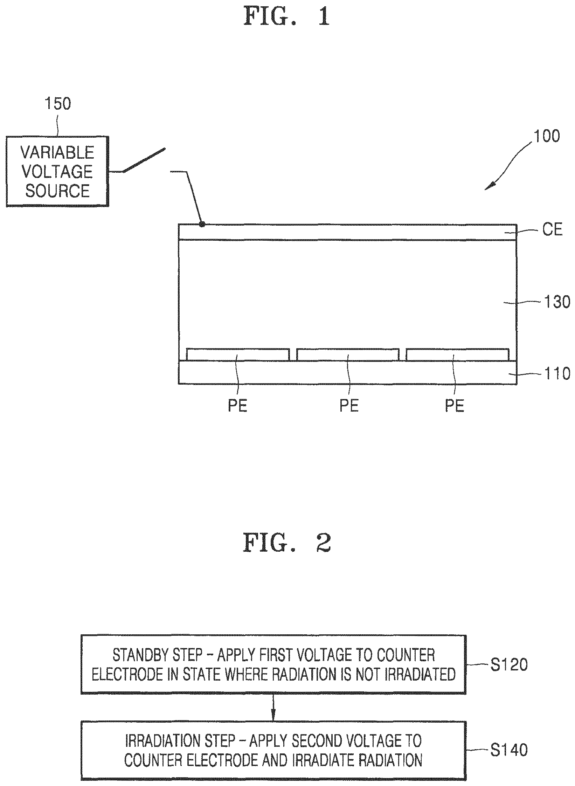

FIG. 1 is a cross-sectional view illustrating a schematic structure of a radiation detection apparatus 100 according to an example embodiment.

Referring to FIG. 1, the radiation detection apparatus 100 includes an array substrate 110 in which a plurality of pixel electrodes PE are formed, a counter electrode CE that faces the plurality of pixel electrodes PE, and a photoconductor layer 130 that is disposed between the plurality of pixel electrodes PE and the counter electrode CE. The radiation detection apparatus 100 further includes a variable voltage source 150 that applies a variable voltage to the counter electrode CE.

The plurality of pixel electrodes PE may be formed on the array substrate 110 in a two-dimensional (2D) array. A charging capacitor and a transistor, which are respectively connected to the plurality of pixel electrodes PE, may be further formed on the array substrate 110.

The counter electrode CE may be disposed to face the plurality of pixel electrodes PE. The counter electrode CE may be an electrode for generating an electric field in the photoconductor layer 130, and may be referred to as a common electrode in a sense of applying a common voltage having a polarity opposite to each of the plurality of pixel electrode PE.

The photoconductor layer 130 may be formed of an optical-to-electric conversion material that has conductivity due to light. The optical-to-electric conversion material is a material that has properties of a dielectric when light is not irradiated, but has properties of a conductor when light is irradiated. In an example embodiment, as an example of the optical-to-electric conversion material, a material that has a characteristic of generating an electric charge by reacting to radiation such as an X-ray or a gamma ray (y-ray) may be used for the photoconductor layer 130. That is, the radiation detection apparatus 100 according to an example embodiment may be an X-ray detector or a gamma ray (y-ray) detector.

When radiation is irradiated onto the photoconductor layer 130, an electron may be excited to a conduction band by energy of the irradiated radiation. In a state where an electric field is not generated in the photoconductor layer 130, electrons excited by radiation are again shifted to a ground state and form a valence band. When radiation is irradiated in a state where an electric field is generated in the photoconductor layer 130, electric charges that form the conduction band due to radiation energy move along a direction of the electric field. The moved electric charges may be collected, and may be used to generate a radiation image.

The photoconductor layer 130 may be formed of various kinds of photoconductive materials. The photoconductor layer 130 may include, for example, HgI₂, HgO, PbI₂, CdTe, CdZnTe, PbO, PbO₂, CdS, or BiI₃. The materials may absorb radiation (an X-ray or a gamma ray) well in a thin thickness because the atomic weight of the materials is large and a density of the materials is high, and since ionization energy caused by radiation is small, the materials may show good photoconductive performance. Since the materials may show good photoconductive performance, the conversion efficiency of absorbing radiation and generating an electron-hole pairs may be high. That is, the good photoconductive performance denotes that since quantum efficiency is high, the number of electron-hole pairs generated by irradiated radiation is large.

As conversion efficiency becomes lower, a thickness of the photoconductor layer 130 may be thicker to obtain a desired electrical signal. Since a distance by which an electric charge is moved in the photoconductor layer 130 is long for collecting electric charges generated by radiation, a higher electric field is generated in a case, where the thickness of the photoconductor layer 130 is thick, than a case where the thickness of the photoconductor layer 130 is thin. Therefore, when an optical-to-electric conversion material having high conversion efficiency is used for the photoconductor material 130, the thickness of the photoconductor layer 130 may be relatively thin, and electric charges may be collected with a relatively lower bias voltage.

For example, in amorphous selenium (a-Se), a bias voltage of several KV to several tens KV may be needed for detection an electric charge reacting on radiation. On the other hand, in mercury iodide HgI₂, an electric charge caused by radiation may be detected by using a bias voltage of several hundreds V, for example, a bias voltage of about 300 V or less.

The photoconductor layer 130 may be formed by a particle-in-binder (PIB) process. According to the PIB process, the photoconductor layer 130 is formed by performing thermal treatment on a paste in which photoconductive particles are mixed with a binder. The photoconductive particles are materials having optical-to-electric conversion characteristic, and may include HgI₂, HgO, PbI₂, CdTe, CdZnTe, PbO, PbO₂, CdS, or BiI₃. The binder is a material that is mixed with the photoconductive particles to apply an adhesive force, and may use an organic polymer material.

The PIB process is known as a process of thickly forming the photoconductor layer 130 to have a large area. However, a process of forming the photoconductor layer 130 is not limited thereto, and the photoconductor layer 130 may be formed by a physical vapor deposition (PVD) process. That is, the photoconductor layer 130 may be formed by a process that evaporates a target, formed of one or two or more compounds of the optical-to-electric conversion materials, by applying a physical force to the target.

The variable voltage source 150 applies a voltage to the counter electrode CE to generate an electric field in the photoconductor layer 130. In some example embodiments, the variable voltage source 150 applies different voltages to the counter electrode CE depending on an operation performed by the radiation detection apparatus 100.

For example, the variable voltage source 150 may apply different voltages to the counter electrode CE in a standby operation where radiation is not irradiated onto the photoconductor layer 130 and in an irradiation operation where the radiation is irradiated onto the photoconductor layer 130.

Hereinafter, the voltage that is applied to the counter electrode CE in the standby operation is referred to as a first voltage, and the voltage that is applied to the counter electrode CE in the irradiation operation is referred to as a second voltage.

The first voltage is a voltage that is applied to the counter electrode CE so that an electric field is not generated (or, alternatively, reduced or minimized) in the photoconductor layer 130, and the second voltage is a voltage for generating an electric field, which moves an electric charge that is generated by radiation to the pixel electrodes PE, in the photoconductor layer 130. The second voltage may have an absolute value greater than the first voltage, and a value of the second voltage may be determined based on a material forming the photoconductor layer 130. For example, in HgI₂, the second voltage may be a value of about 300 V or less.

An optical-to-electric conversion material forming the photoconductor layer 130 may have a finite electric conductivity that is greater than 0. Therefore, when an electric field is generated in the photoconductor layer 130 even in a state where radiation is not irradiated, a flow of an electric charge (e.g. a current) may occur.

The current flowing when no radiation is irradiated may be called dark current. The dark current is distinguished from a photocurrent that flows in response to electric charges generated by radiation. If there is dark current present when detecting the photocurrent, the dark current may generate noise.

One or more example embodiments may reduce the dark current, and, thus the noise generated thereby, via a variable voltage driving method in which the voltage generated by the variable voltage source 150 varies to reduce (or, alternatively, minimize) the dark current which is generated in the photoconductor layer 130 before radiation is irradiated onto the photoconductor layer 130.

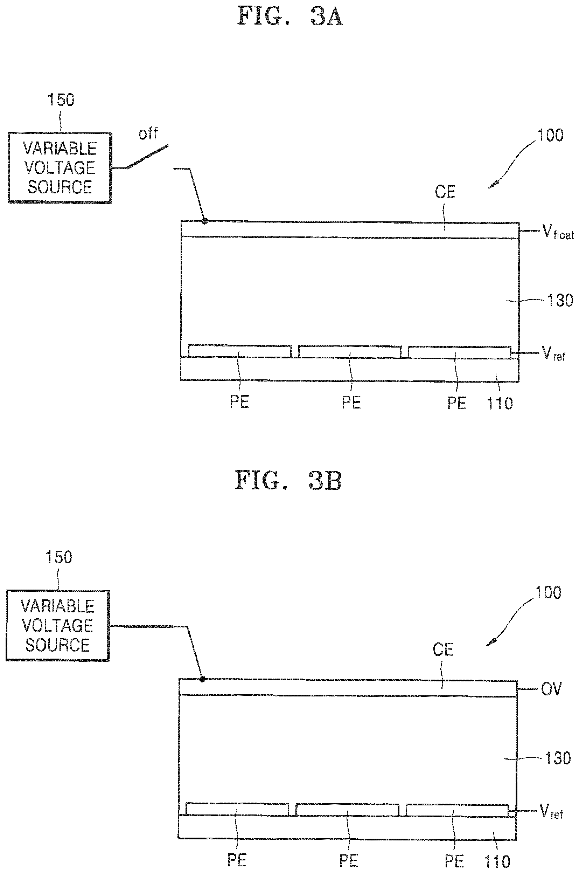

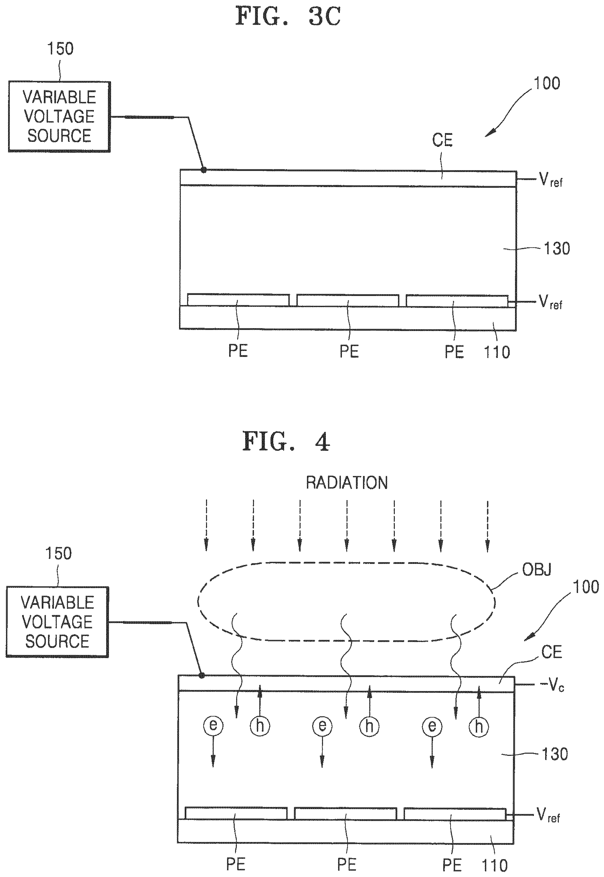

FIG. 2 is a flowchart for describing a method of driving a radiation detection apparatus according to an example embodiment. FIGS. 3A to 3C are diagrams illustrating examples of a first voltage which is applied to a counter electrode of a radiation detection apparatus in a standby operation of the flowchart of FIG. 2. FIG. 4 is a diagram for describing an operation in which a second voltage is applied to the counter electrode of the radiation detection apparatus, and when radiation is irradiated onto a photoconductor layer, a photocurrent is generated by the radiation, in an irradiation operation of the flowchart of FIG. 2.

Referring to FIGS. 2 to 4, a method of driving a radiation detection apparatus will be described by using the radiation detection apparatus 100 of FIG. 1.

In the method of driving a radiation detection apparatus according to an example embodiment, in operation S120, a control unit instructs the variable voltage source 150 to apply the first voltage to the counter electrode CE in a standby operation where radiation is not irradiated onto the photoconductor layer 130.

The first voltage is a voltage that is applied to the counter electrode CE to reduce (or, alternatively, minimize) an electric field generated in the photoconductor layer 130.

An optical-to-electric conversion material forming the photoconductor layer 130 is a material that has properties of a dielectric in a state where radiation is not irradiated, and when the radiation is irradiated, has properties of a conductor.

A resistivity of the photoconductor layer 130 is very large, but may not be infinite. Therefore, an electric conductivity of the photoconductor layer 130 may not completely 0 even before radiation is irradiated, and instead may have a value that is substantially greater than 0. For example, in HgI₂, electron mobility associated with electric conductivity is about 10⁻⁴(cm²/(V • s)), hole mobility associated with electric conductivity is about 10⁻⁶(cm²/(V • s)), and resistivity is about 10¹³(Ωcm).

Therefore, in a case where an electric field is generated in the photoconductor layer 130, even when radiation is not irradiated onto the photoconductor layer 130, a flow of an electric charges may occur in the photoconductor layer 130. The flow of the electric charges may generate a dark current, and may cause a noise component to be present in an image signal.

As discussed below, in one or more example embodiments, a control unit drives the radiation detection apparatus 100 by applying a variable voltage to reduce (or, alternatively, minimize) the dark current.

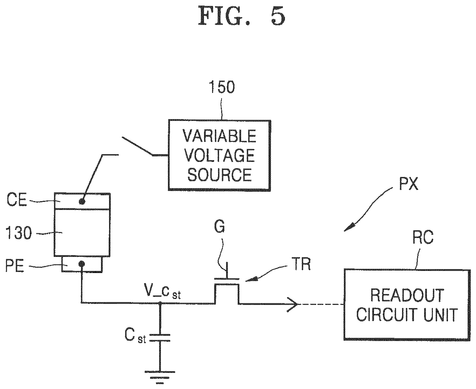

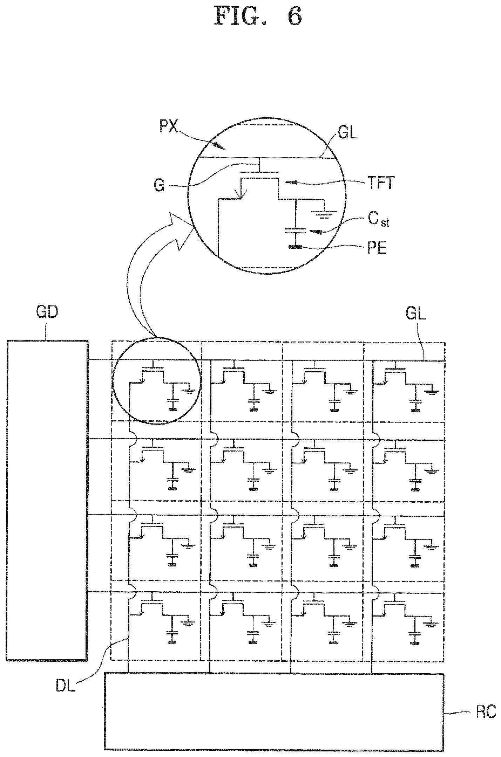

Referring to FIG. 3A, the first voltage may be a floating voltage V_{float}. That is, an off state in which an electrical connection between the variable voltage source 150 and the counter electrode CE is disconnected is formed. An electric potential V_{ref} generated in the pixel electrode PE is a value corresponding to a reference common voltage of a readout circuit unit (See FIGS. 5 and 6) connected to the array substrate 110, and is about 4 V to about 5 V. The floating voltage V_{float} applied to the counter electrode CE may be such that a certain electric potential is not maintained, and a substantially meaningful electric field is not generated between the counter electrode CE and the pixel electrode PE to which the electric potential V_{ref} is applied.

Referring to FIG. 3B, the first voltage is 0 V. The electric potential V_{ref} applied to the pixel electrode PE is a value close to 0, and an electric field is hardly generated in the photoconductor layer 130.

Referring to FIG. 3C, the first voltage may be the same value V_{ref} as an electric potential of the pixel electrode PE. In detail, a value which is substantially equivalent to the reference common voltage of the readout circuit unit connected to the pixel electrode PE may be applied to the counter electrode CE.

As discussed above, the floating voltage (FIG. 3A), 0 V (FIG. 3B), and the voltage Vref (FIG. 3C) may each be the first voltage applied to the counter electrode CE. However, example embodiments are not limited thereto.

For example, the control unit (not shown) may select the first voltage to reduce, prevent or minimize a dark current which is generated in a state where radiation is not irradiated onto the photoconductor layer 130, and, therefore, a value within a range in which an electric field is not generated in the photoconductor layer 130 or which is suitable for minimizing the electric field may be selected.

Referring back to FIG. 2, after the standby operation in which the first voltage is applied to the counter electrode CE, in operation S140, the control unit (not shown) may instruct the variable voltage source 150 to apply the second voltage to the counter electrode CE, and radiation is irradiated.

Referring to FIG. 4, the second voltage applied to the counter electrode CE may be - Vc. The voltage Vc may be determined based on an optical-to-electric conversion material forming the photoconductor layer 130, and a value of several hundreds V may be applied for driving a variable voltage. For example, Vc may be a value of about 300 V or less, or may be a value within a range of about 200 V to about 300 V. V_{ref} of several V is applied as the reference common voltage of the readout circuit unit, and an electric field is generated in the photoconductor layer 130 in a direction from the pixel electrode PE to the counter electrode CE.

Radiation irradiated onto an object OBJ passes through the object OBJ and is incident on the photoconductor layer 130. As the radiation is incident on the photoconductor layer 130, an electron-hole pair (e-h pair) may be generated in the photoconductor layer 130.

The electron-hole pair may be separated into an electron (e) and a hole (h) by the electric field generated in the photoconductor layer 130. The electron (e) may move to the pixel electrode PE, and the hole (h) may move to the counter electrode CE. An amount of electric charge (i.e., the number of generated electrons and holes) generated in the photoconductor layer 130 varies depending on a transmission amount of the radiation passing though the object OBJ, namely, an amount of electric charge detected through each of the plurality of pixel electrodes PE is changed. Based on such a difference, the inside of the object OBJ may be imaged.

FIG. 5 is a schematic diagram illustrating a transistor TR and a charging capacitor Cₛₜ, which are formed on an array substrate of a radiation detection apparatus according to an example embodiment, for one pixel PX.

Referring to FIG. 5, the pixel electrode PE is connected to the charging capacitor Cₛₜ. The charging capacitor Cₛₜ is used to collect electric charges, which are generated in the photoconductor layer 130, through the pixel electrode PE. The transistor TR acts as a switch for controlling an output (i.e., discharging) of electric charges stored in the charging capacitor Cₛₜ, to the outside. One electrode (for example, a source electrode) of the transistor TR is connected to the charging capacitor Cₛₜ, and the other electrode (for example, a drain electrode) is connected to a readout circuit unit RC.

Each of the pixel PXs may include one of the pixel electrodes PE, the charging capacitor Cₛₜ connected to the pixel electrode PE, and the transistor TR connected to the pixel electrode PE.

FIG. 6 is a circuit diagram illustrating an example of a circuit configuration of a radiation detection apparatus according to an example embodiment.

Referring to FIG. 6, a plurality of pixels PX are two-dimensionally arranged in a pixel array.

The pixel array may include a plurality of gate lines which extend in a first direction separated from each other at certain intervals, and a plurality of data lines DL which extend to intersect the plurality of gate lines GL.

The pixels PX may be provided in each of a plurality of regions formed by intersections of the plurality of gate lines GL and the plurality of data lines DL. Each of the pixels PX may include the pixel electrode PE, the charging capacitor Cₛₜ, and the transistor TR.

Further, a gate driver GD may be connected to the plurality of gate lines GL, and the readout circuit unit RC may be connected to the plurality of data lines DL.

When a gate voltage is applied to a gate G of the transistor TR via a corresponding gate line GL, a channel may be formed between the source electrode and drain electrode of the transistor TR, and electric charges stored in the charging capacitor Cₛₜ may be output through a corresponding data line DL and read by the readout circuit unit RC.

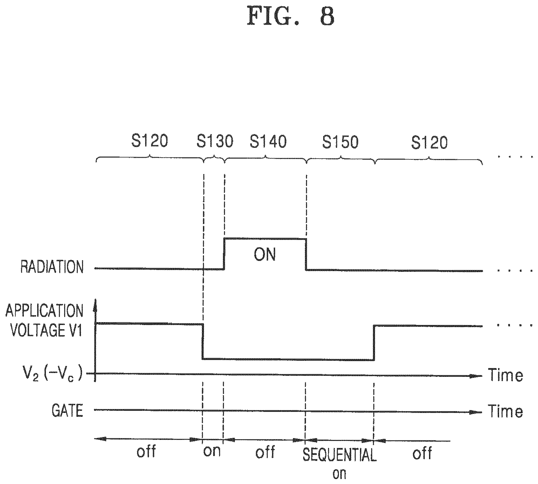

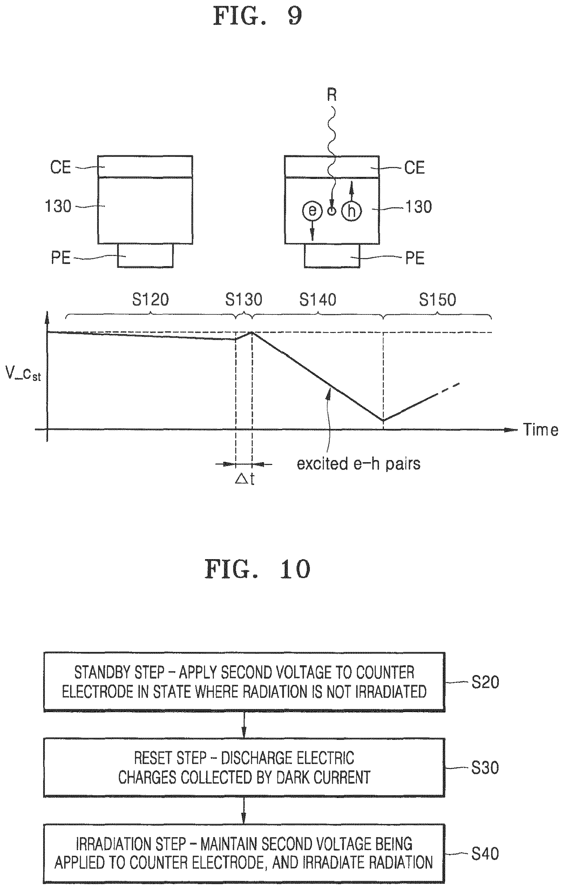

FIG. 7 is a block diagram illustrating in detail driving of a radiation source, a variable voltage source, a gate, and a charging capacitor in each operation of a method of driving a radiation detection apparatus according to an example embodiment. FIG. 8 is a graph showing driving of the radiation source, an application voltage, and a gate with time in each operation of a method of driving a radiation detection apparatus according to an example embodiment. FIG. 9 is a graph showing a change in a capacitor voltage in each operation of a method of driving a radiation detection apparatus according to an example embodiment.

The method of driving the radiation detection apparatus according to an example embodiment may include the standby operation S120, a reset operation S130, the irradiation operation S140, and a scan operation S150.

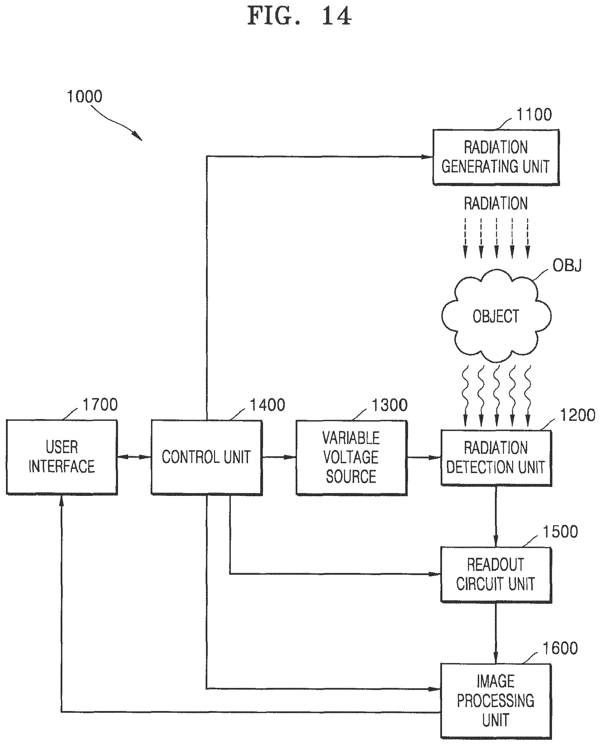

In the Standby operation S120 the control unit (see FIG. 14) may instruct a radiation generating unit (see FIG. 14) not to irradiate radiation onto the photoconductor layer 130, and further, may instruct the variable voltage source 150 to apply the first voltage V1 to the counter electrode CE.

During the Standby operation S120, the gate of the transistor TR connected to the pixel electrode PE is in an off state, namely, a state in which a gate voltage is not applied, and the charging capacitor Cₛₜ is in a chargeable state.

The first voltage applied by the variable voltage source 150 may be the floating voltage, 0 V, or a low voltage of 4 V to 5 V, and, thus, at most, a relatively small electric field is generated in the photoconductor layer 130.

When an electric field is generated in the photoconductor layer 130, electric charges may flow, and thus, the charging capacitor Cₛₜ may be charged. For example, when an electron moves to the pixel electrode PE in the photoconductor layer 130, as illustrated in FIG. 9, the charging capacitor Cₛₜ may be charged, and thus, a capacitor voltage V_{_Cst} may be lowered.

However, as illustrated in FIG. 9, in the method of driving the radiation detection apparatus according to an example embodiment, during the standby operation S120, the control unit (see FIG. 14) instructs the variable voltage source 150 to apply the first voltage V1 to the counter electrode CE. Therefore, an electric field is hardly generated in the photoconductor layer 130, and the capacitor voltage V_{_Cst} is hardly changed or is slightly changed.

In the Reset operation S130, the control unit (see FIG. 14) initializes the charging capacitor Cₛₜ by discharging electric charges stored in the charging capacitor Cₛₜ. During the Reset operation S130, the control unit may instruct the radiation generating unit not to irradiate radiation onto the photoconductor layer 130, and the variable voltage source 150 to apply the second voltage to the counter electrode CE. Also, the gate voltage is applied to the gate G of the transistor TR, and thus, a channel is formed between the source electrode and drain electrode of the transistor TR, and the electric charges stored in the charging capacitor Cₛₜ are discharged. As illustrated in FIG. 9, the capacitor voltage V_{_Cst} returns to an initial state as the charging capacitor Cₛₜ discharges.

In the method of driving the radiation detection apparatus according to an example embodiment, due to the control unit applying the first voltage V1 to the counter electrode CE to reduce the dark current during the standby operation S120, a time "Δt" taken to perform the Reset operation S130 is reduced.

In the method of driving the radiation detection apparatus according to some example embodiments, Reset operation S130 may be omitted all together.

During the Reset operation S130, the second voltage is applied to the counter electrode CE prior to a radiation irradiation timing, and after an electric field is generated in the photoconductor layer 130, radiation is irradiated onto an object, and electric charges generated by the radiation are collected. Therefore by performing the Reset operation S130 prior to the irradiation of radiation, a time for which the object is exposed to the radiation may be reduced.

In the Irradiation operation S140, the control unit may instruct the radiation generating unit to irradiate radiation onto the photoconductor layer 130 in a state where the variable voltage source 150 applies the second voltage V2 to the counter electrode CE. The second voltage V2 may be - Vc. The second voltage Vc may be a value which is determined based on a material of the photoconductor layer 130, and may have a value of about 300 V or less.

In irradiation operation S140, electric charges generated by radiation R irradiated onto the photoconductor layer 130 may be collected by the charging capacitor Cₛₜ connected to each of the plurality of pixel electrodes PE. An electron-hole pair generated in the photoconductor layer 130 is separated into an electron and a hole by an electric filed generated in the photoconductor layer 130, and the electron and the hole respectively move to the pixel electrode PE and the counter electrode CE. The gate of the charging capacitor Cₛₜ is turned off, and the electron moving to the pixel electrode PE is stored in the charging capacitor Cₛₜ.

As illustrated in FIG. 9, as the charging capacitor Cₛₜ is charged, the capacitor voltage V_{_Cst} is lowered. During the irradiation operation S140, the change in the capacitor voltage V_{_Cst} is caused by an electron (e)-hole (h) pair excited by the radiation R being irradiated, and is not caused by a dark current component.

Since an amount of radiation passing through the object OBJ varies depending on a region of the object OBJ through which radiation passes, the number of electron (e)-hole (h) pairs generated in the photoconductor layer 130 may also vary depending on a region of the photoconductor layer 130. Therefore, different amounts of electric charges may be stored in a plurality of the charging capacitors Cₛₜ respectively connected to the plurality of pixel electrodes PE.

In the Scan operation S150, the control unit instructs the transistors TR to sequentially provide the electric charges respectively stored in the plurality of charging capacitors Cₛₜ to the readout circuit unit, and the readout circuit unit may read the electric charges to generate a signal. During the scan operation S150, the control unit may instruct the radiation generating unit to stop the irradiation of radiation. Also, the control unit may instruct the variable voltage source 150 to apply the first voltage V1 to the counter electrode CE. The gate voltage is sequentially applied to the gates of the plurality of transistors TR, and thus, the electric charges stored in the charging capacitors Cₛₜ move to the readout circuit unit.

As illustrated in FIG. 9, as the electric charges stored in the charging capacitors Cₛₜ move to the readout circuit unit, the capacitor voltage V__{Cst} increases again.

The control unit may perform operations S120 to S150, namely, the standby operation S120, reset operation S130, irradiation operation S140, and scan operation S150, repeatedly for continuously photographing images of a plurality of frames.

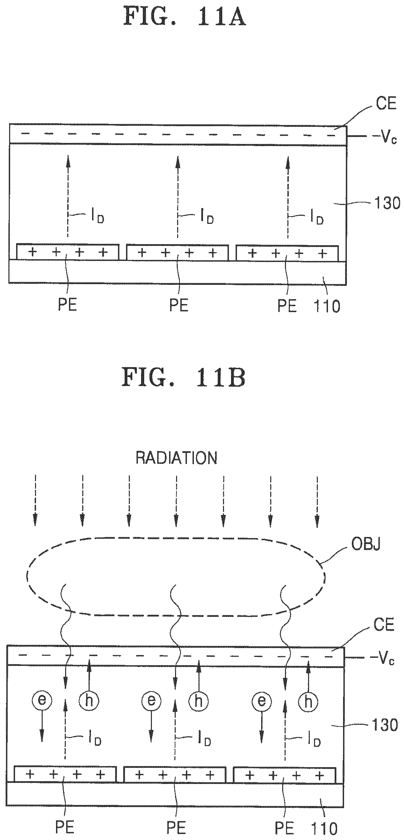

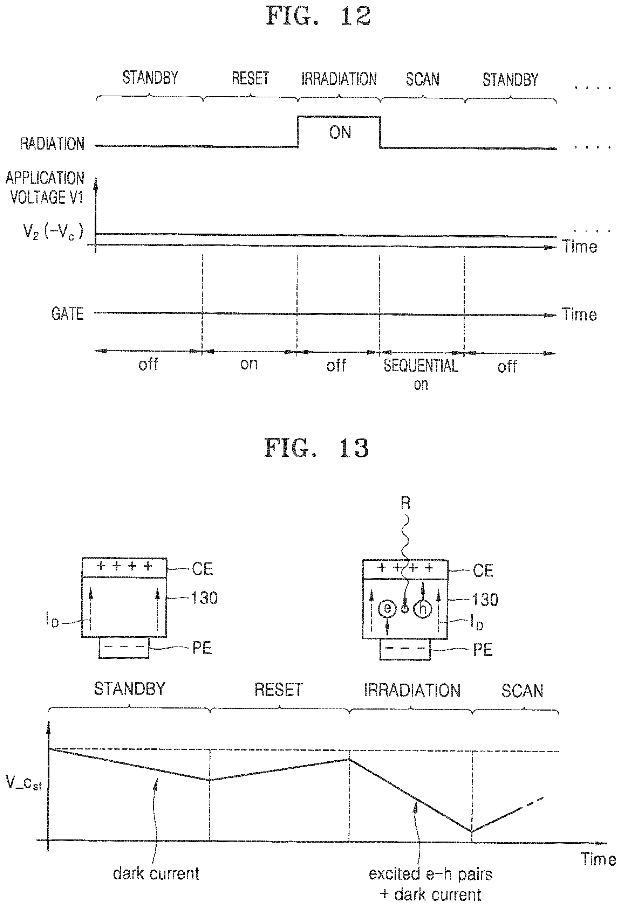

FIG. 10 is a flowchart for describing a method of driving a radiation detection apparatus according to a comparative example. FIGS. 11A and 11B are conceptual diagrams for describing an operation in which an electric charge caused by a dark current is detected along with an electric charge caused by radiation, in a method of driving a radiation detection apparatus according to a comparative example. FIG. 12 is a graph showing driving of radiation, an application voltage, and a gate with time in each step of a method of driving a radiation detection apparatus according to a comparative example. FIG. 13 is a graph showing a change in a capacitor voltage V_{_Cst} in each step of a method of driving a radiation detection apparatus according to a comparative example.

Referring to FIG. 10, the method of driving the radiation detection apparatus according to the comparative example, may include standby step S20, reset step S30, and irradiation step S40. In standby step S20 and reset step S30, a same second voltage V2 may be applied to a counter electrode of the radiation detection apparatus. That is, a voltage applied to the radiation detection apparatus maintains a constant value, and is not changed.

As described below with reference to FIGS. 11A and 11B, in the comparative example, noise may be caused by a dark current.

Referring to FIG. 11A, in standby step S20, since an electric field is generated in a photoconductor layer 130 even though radiation is not irradiated thereto, a flow of an electric charge occurs in the photoconductor layer 130 formed of an optical-to-electric conversion material having finite electric conductivity. The flow of the electric charge during the standby step S20 may be a dark current I_{D}.

As illustrated in FIG. 13, during the standby step S20, a charging capacitor Cst is charged through a pixel electrode PE by the dark current I_{D}, and thus, The capacitor voltage V_{_Cst} changes.

Referring to FIG. 11B, during an irradiation step S40, dark current I_{D} may exist in the photoconductor layer 130, when radiation is irradiated onto an object OBJ. When the radiation passing through the object OBJ is incident on the photoconductor layer 130, an electron (e)-hole (h) pair is generated, and is separated into an electron (e) and a hole (h) by an electric field which is generated in the photoconductor layer 130. The electron (e) moves to the pixel electrode PE, and the hole (h) moves to a counter electrode CE. Electric charges which are stored in the charging capacitor Cₛₜ through the pixel electrode PE include an electric charge, generated by the dark current I_{D}, and an electric charge generated by an electron-hole pair excited by the radiation. When detecting the radiation irradiated during the irradiation step, the electric charges due to by the dark current generated during the standby step S20 may cause noise.

In the method of driving the radiation detection apparatus according to the comparative example, in reset step S30, an operation in which electric charges collected by the dark current are discharged may be used to prevent the noise.

As illustrated in FIG. 13, during the reset step S130, the capacitor voltage V_{_Cst} is initialized by discharging the charging capacitor Cₛₜ. However, in comparison to FIG. 9, the time taken to perform the reset step S30 may be larger due to the increased amount of charges accumulated by the dark current during the standby step S20 in which the first voltage is not applied to the counter electrode CE.

After reset step S30, the irradiation step S40 may be performed. However, when the capacitor voltage V_{_Cst} is not completely restored to the original state in the reset step S30, the electric charges stored in the charging capacitor Cₛₜ may include electric charges generated by an electron-hole pair excited by the radiation R, and also electric charges generated by dark current I_{D}. The charging capacitors Cₛₜ are sequentially discharged in scan step, and when the electric charges generated by the dark current are read by the readout circuit unit, they may cause image noise.

In the method of driving the radiation detection apparatus according to an example embodiment, the reset step may be omitted or may be performed for a short time T, and therefore, any charges accumulated due to dark current may be removed prior to irradiating the photoconductor with radiation. Also, the operations may be repeated in continuous photographing, and thus, in the method of driving the radiation detection apparatus according to an example embodiment, the reset operation may be omitted, or a time taken in the reset operation may be considerably reduced.

FIG. 14 is a block diagram illustrating a schematic configuration of a radiation imaging apparatus 1000 according to an example embodiment.

The radiation imaging apparatus 1000 may include a radiation generating unit 1100 that irradiates radiation onto an object OBJ, a radiation detection unit 1200 that detects the radiation passing through the object OBJ, a variable voltage source 1300 that applies a variable voltage to the radiation detection unit 1200, and a control unit 1400 that controls the variable voltage source 1300.

The radiation imaging apparatus 1000 may further include a readout circuit unit 1500, which reads out an electrical signal from the radiation detection unit 1200 for each pixel, and an image processing unit 1600 that generates a radiation image of the object OBJ from the electrical signal which is read out by the readout circuit unit 1500 for each pixel. Also, the radiation imaging apparatus 1000 may further include a user interface 1700 that provides an interface between the radiation imaging apparatus 1000 and a user.

The radiation generating unit 1100 includes a radiation source that emits radiation. The radiation source may be, for example, a radiation tube including a cathode and an anode. An electromagnetic wave (for example, radiation such as an X-ray or a gamma ray) having a short wavelength may be generated by colliding an electron ray, which is emitted from the cathode of the radiation tube by vacuum discharging at a high speed, with the anode. The anode may use a metal material such as tungsten or molybdenum. A radiation spectrum may be changed depending on a material of the anode.

The radiation source emits radiation having certain energy, thereby enabling a single energy radiation image to be acquired. As another example, the radiation source irradiates a plurality of radiations having different energy a plurality of times, thereby enabling a multi-energy X-ray image (MEX) to be acquired. Also, the radiation generating unit 1100 may include a filter, which adjusts a radiation spectrum, and a collimator that controls an irradiation direction or an irradiation range of radiation.

The radiation detection unit 1200 receives radiation, which is irradiated from the radiation generating unit 1100 and passes through the object OBJ, to output an electrical signal. The radiation detection unit 1200 includes a plurality of pixel electrodes, a counter electrode that faces the plurality of pixel electrodes, and a photoconductor layer that is disposed between the plurality of pixel electrodes and the counter electrode. Also, the radiation detection unit 1200 includes a capacitor and a transistor that are connected to each of the plurality of pixel electrodes.

The radiation detection unit 1200, for example, may be disposed at an inner surface or a lower end of a rest (not shown) on which the object OBJ is located.

The variable voltage source 1300 applies a variable voltage to the counter electrode of the radiation detection unit 1200. For example, the control unit 1400 may control the variable voltage source 1300 to apply a first voltage to the counter electrode in a state where radiation is not irradiated onto the object OBJ, and to apply a second voltage, having an absolute value greater than the first voltage, to the counter electrode in a state where the radiation is irradiated onto the object OBJ.

The first voltage, which is applied to the radiation detection unit 1200 by the variable voltage source 1300, is used to reduce (or, alternatively, minimize) a dark current in a state where the radiation is not irradiated onto the object OBJ. Therefore, a time taken in a reset step (i.e., a time taken in initializing a capacitor voltage) performed before an irradiation step of applying the second voltage to the radiation detection unit 1200 and irradiating the radiation is reduced (or, alternatively, minimized), and it is possible to capture an image at a high speed.

The readout circuit unit 1500 is connected to each pixel of the radiation detection unit 1200, and reads out an electrical signal output from the radiation detection unit 1200 for each pixel.

The image processing unit 1600 may generate a radiation image, based on the electrical signal which is read out by the readout circuit unit 1500 for each pixel. For example, the image processing unit 1600 may estimate strength of the radiation, based on an intensity of the electrical signal detected from each pixel and thus substitute a certain image value into a pixel of a radiation image corresponding to each pixel, thereby generating a radiation image.

The radiation imaging apparatus 1000 may further include an image post-processing unit that performs post-processing on the radiation image processed by the image processing unit 1600. The image post-processing unit may correct a brightness, a color, a contrast, or a sharpness of the radiation image to correct the radiation image. As another example, the image post-processing unit may generate a three-dimensional stereoscopic radiation image by using a plurality of radiation images.

The above-described image processing unit 1600 has been described above as being included in the radiation imaging apparatus 1000. However, this is merely an example, and the example embodiments are not limited thereto. For example, the image processing unit 1600 may be provided in a workstation which is connected to the radiation imaging apparatus 1000 over a wired/wireless communication network.

The control unit 1400 may control the variable voltage source 1300 as described above, and moreover control an overall operation of the radiation imaging apparatus 1000. For example, the control unit 1400 may transfer a control signal, which is generated according to an input from a user, to the radiation generating unit 1100, the readout circuit unit 1500, or the image processing unit 1600 to control the overall operation of the radiation imaging apparatus 1000.

The control unit 1400 may include a processor and a memory (not shown).

The memory may be any device capable of storing data including magnetic storage, flash storage, etc. The processor may be any device capable of processing data including, for example, a microprocessor configured to carry out specific operations by performing arithmetical, logical, and input/output operations based on input data, or capable of executing instructions included in computer readable code stored in the memory. The processor may be a logic chip, for example, a central processing unit (CPU), a controller, or an application-specific integrated circuit (ASIC), that when, executing the instructions stored in the memory, configures the processor as a special purpose machine to perform the operations illustrated in FIG. 7 such that the processor is configured to reduce a dark current by reducing an electric field between the counter electrode CE and the pixel electrode PE. For example, the processor may instruct the variable voltage source 150, 1300 to apply a first voltage to the counter electrode CE in a state where radiation is not irradiated onto the object OBJ, and to apply a second voltage, having an absolute value greater than the first voltage, to the counter electrode CE in a state where the radiation is irradiated onto the object OBJ. Therefore, since the processor reduces the amount of dark current, the processor may improve the functioning of the control unit 1400 itself by reducing a time taken to initialize a capacitor voltage before irradiating the photoconductor with radiation, and, therefore, the processor may allow an imaging device to capture an image at a high speed.

In detail, the control unit 1400 may receive an instruction or a command of the user or various information through the user interface 1700, and control a certain operation of the radiation imaging apparatus 1000 by using the received instruction, command, or various information. Also, the control unit 1400 may control the certain operation of the radiation imaging apparatus 1000 according to a predetermined setting. For example, the control unit 1400 may transfer, to the radiation generating unit 1100, an amount of radiation to be irradiated or a control signal for irradiation start.

The user interface 1700 is an interface between a user and the radiation imaging apparatus 1000, and includes an input unit and an output unit. Information necessary for operating the radiation imaging apparatus 1000 is input through the user interface 1700, and an analyzed result may be output through the user interface 1700. For example, information, an instruction, or a command is input from the user through the input unit, and the input unit may include various buttons, a keyboard, a mouse, a trackball, a trackpad, a dome switch, a touch pad, a touch screen panel, various levers, a handle, or a stick. Also, the output unit may include a display unit and a sound output unit. The display unit may display a radiation image generated by the image processing unit 1600. The display unit may use various display panels such as a liquid crystal display (LCD) panel, an organic light-emitting diode (OLED) display panel, etc., and may also use a three-dimensional display panel. Also, the sound output unit may output a sound signal that notifies the start or end of capturing of a radiation image. The sound output unit may include a speaker and a buzzer.

The user interface 1700 has been described above as being included in the radiation imaging apparatus 1000. However, this is merely an example, and the example embodiments are not limited thereto. For example, the user interface 1700 may be provided in a separate workstation which transmits or receives data to or from the radiation imaging apparatus 1000 over the wired/wireless communication network.

The radiation imaging apparatus 1000 may further include a memory that stores a program executed in the control unit 1400, data necessary for control by the control unit 1400, or an image generated by the image processing unit 1600.

As described above, according to the one or more of the above example embodiments, the occurrence of a dark current is minimized in a standby step where radiation is not irradiated onto the photoconductor layer of the radiation detection apparatus.

In the method of driving the radiation detection apparatus according to an example embodiment, an initialization operation which is performed before radiation is irradiated is omitted or is performed for a short time, and thus, it is possible to drive the radiation detection apparatus at a high speed.

The radiation imaging apparatus according to an example embodiment acquires a good-quality radiation image at a high speed.

It should be understood that the example embodiments described therein should be considered in a descriptive sense only and not for purposes of limitation. Descriptions of features or aspects within each example embodiment should typically be considered as available for other similar features or aspects in other example embodiments.

While one or more example embodiments have been described with reference to the figures, it will be understood by those of ordinary skill in the art that various changes in form and details may be made therein without departing from the scope as defined by the following claims.

## Claims

1. A method of driving a radiation detection apparatus, the radiation detection apparatus including a plurality of pixel electrodes, a counter electrode facing the plurality of pixel electrodes, a photoconductor layer between the plurality of pixel electrodes and the counter electrode, a plurality of capacitors connected to respective ones of the plurality of pixel electrodes, and a plurality of transistors configured to selectively discharge the plurality of capacitors, the method comprising the following subsequent operations in the given order:
a standby operation during which a first voltage is applied to the counter electrode while no radiation is irradiated to the photoconductor layer and a gate voltage is not applied to a gate of the transistor of each pixel electrode;
a reset operation during which a second voltage is applied to the counter electrode while no radiation is irradiated to the photoconductor layer and the gate voltage is applied to the gate of the transistor of each pixel electrode, the second voltage having an absolute value greater than the first voltage;
an irradiation operation during which the second voltage is applied to the counter electrode while radiation is irradiating onto the photoconductor layer and the gate voltage is not applied to the gate of the transistor of each pixel electrode; and
a scan operation during which the first voltage is applied to the counter electrode while no radiation is irradiated to the photoconductor layer and a gate voltage is sequentially applied to the gates of the plurality of transistors.

2. The method of claim 1, wherein the first voltage is 0 V or a floating voltage.

3. The method of claim 1 or 2, wherein the plurality of pixel electrodes and the counter electrode have an equivalent electric potential due to a value of the first voltage applied to the counter electrode.

4. The method of claim 1, wherein the radiation detection apparatus further comprises:
a readout circuit unit connected to the plurality of pixel electrodes, and wherein
the first voltage is equivalent to a reference common voltage of the readout circuit unit.

5. The method of any one of claims 1 to 4, wherein an absolute value of the second voltage is 300 V or less.

6. The method of any one of claims 1 to 5, wherein the radiation detection apparatus further includes a capacitor connected to each of the plurality of pixel electrodes, and the method further comprises:
discharging an electric charge stored in a capacitor after the standby operation and before the irradiating operation.

7. The method of claim 6, further comprising:
collecting, during the irradiation operation, electric charges generated by the radiation irradiated onto the photoconductor layer in the capacitor connected to each of the plurality of pixel electrodes, and
sequentially discharging the capacitor so that the electric charges stored in the capacitor are read by the readout circuit unit.

8. A radiation detection apparatus (100; 1000) comprising:
a substrate (110) having a plurality of pixel electrodes (PE) arranged thereon;
a counter electrode (CE) facing the plurality of pixel electrodes;
a photoconductor layer (130) between the plurality of pixel electrodes and the counter electrode, the photoconductor layer configured to generate an electric charge in response to radiation irradiated thereon;
a plurality of capacitors connected to respective ones of the plurality of pixel electrodes;
a plurality of transistors configured to selectively discharge the plurality of capacitors;
a readout circuit unit (1500) connected to the plurality of transistors;
a voltage source (150; 1300) configured to apply a variable voltage to the counter electrode; and
a control unit (1400) configured to
instruct the voltage source to apply, during a standby operation, a first voltage to the counter electrode while no radiation is irradiated to the photoconductor layer and a gate voltage is not applied to a gate of a transistor of each pixel electrode;
instruct the voltage source to apply, during a reset operation, a second voltage to the counter electrode while no radiation is irradiated to the photoconductor layer and the gate voltage is applied to the gate of the transistor of each pixel electrode, the second voltage having an absolute value greater than the first voltage;
instruct the voltage source to apply, during an irradiation operation, the second voltage to the counter electrode while radiation is irradiating onto the photoconductor layer and the gate voltage is not applied to the gate of the transistor of each pixel electrode; and
instruct the voltage source to apply, during a scan operation, the first voltage to the counter electrode while no radiation is irradiated to the photoconductor layer and a gate voltage is sequentially applied to the gates of the plurality of transistors.

9. The radiation detection apparatus of claim 8, wherein the controller is configured to set the first voltage to 0 V or a floating voltage.

10. The radiation detection apparatus of claim 8 or 9, wherein the controller is configured to set a value of the first voltage such that the plurality of pixel electrodes and the counter electrode have equivalent electric potentials.

11. The radiation detection apparatus of claim 8, wherein the controller is configured to set the first voltage to be equivalent to a reference common voltage of the readout circuit unit.

12. The radiation detection apparatus of any one of claims 8 to 11, wherein the photoconductor layer comprises:
a photoconductive material including one of HgI₂, HgO, PbI₂, CdTe, CdZnTe, PbO, PbO₂, CdS, and BiI₃.

13. The radiation detection apparatus of any one of claims 8 to 12, wherein the controller is configured to set an absolute value of the second voltage to 300 V or less.

14. A radiation imaging apparatus comprising:
a radiation generator (1100) configured to irradiate radiation onto an object (OBJ);
a radiation detector apparatus of any one of claims 8 to 13.

## Patentansprüche

1. Verfahren zur Ansteuerung einer Strahlungsdetektionsvorrichtung, wobei die Strahlungsdetektionsvorrichtung mehrere Pixelelektroden, eine Gegenelektrode, die den mehreren Pixelelektroden zugewandt ist, eine Fotoleiterschicht zwischen den mehreren Pixelelektroden und der Gegenelektrode, mehrere Kondensatoren, die mit entsprechend einer der mehreren Pixelelektroden verbunden sind, und mehrere Transistoren aufweist, die ausgebildet sind, die mehreren Kondensatoren selektiv zu entladen, wobei das Verfahren die nachfolgenden Schritte in der gegebenen Reihenfolge umfasst:
einen Bereitschaftsschritt, während welchem eine Spannung an die Gegenelektrode angelegt wird, während keine Strahlung auf die Fotoleiterschicht auftrifft und eine Gatespannung nicht an ein Gate des Transistors jeder Pixelelektrode angelegt wird;
einen Rücksetzschritt, während welchem eine zweite Spannung an die Gegenelektrode angelegt wird, während keine Strahlung auf die Fotoleiterschicht auftrifft, und die Gatespannung an das Gate des Transistors jeder Pixelelektrode angelegt wird, wobei die zweite Spannung einen Absolutwert hat, der größer ist als derjenige der ersten Spannung;
einen Bestrahlungsschritt, während welchem die zweite Spannung an die Gegenelektrode angelegt wird, während Strahlung auf die Fotoleiterschicht auftrifft, und die Gatespannung an das Gate des Transistors jeder Pixelelektrode angelegt wird; und
einen Abtastschritt, während welchem die erste Spannung an die Gegenelektrode angelegt wird, während keine Strahlung auf die Fotoleiterschicht auftrifft, und eine Gatespannung der Reihe nach an das Gate der mehreren Transistoren angelegt wird.

2. Verfahren nach Anspruch 1, wobei die erste Spannung 0 V oder eine bezugspunktfreie Spannung ist.

3. Verfahren nach Anspruch 1 oder 2, wobei die mehreren Pixelelektroden und die Gegenelektrode aufgrund eines Wertes der ersten Spannung, die an die Gegenelektrode angelegt wird, ein gleiches elektrisches Potenzial haben.

4. Verfahren nach Anspruch 1, wobei die Strahlungsdetektionsvorrichtung ferner aufweist:
eine Ausleseschaltungseinheit, die mit den mehreren Pixelelektroden verbunden ist, und wobei
die erste Spannung gleich einer gemeinsamen Referenzspannung der Ausleseschaltungseinheit ist.

5. Verfahren nach einem der Ansprüche 1 bis 4, wobei ein Absolutwert der zweiten Spannung 300 V oder weniger beträgt.

6. Verfahren nach einem der Ansprüche 1 bis 5, wobei die Strahlungsdetektionsvorrichtung ferner einen Kondensator aufweist, der mit jeder der mehreren Pixelelektroden verbunden ist, und wobei das Verfahren ferner umfasst:
Entladen einer in dem Kondensator enthaltenen elektrischen Ladung nach dem Bereitschaftsschritt und vor dem Bestrahlungsschritt.

7. Verfahren nach Anspruch 6, das ferner umfasst:
Sammeln elektrischer Ladungen, die durch die auf die Fotoleiterschicht auftreffende Strahlung erzeugt werden, in dem mit jeder der mehreren Pixelelektroden verbundenen Kondensator während des Bestrahlungsschritts, und
sequenzielles Entladen des Kondensators derart, dass die in dem Kondensator gespeicherte elektrische Ladung von der Ausleseschaltungseinheit ausgelesen wird.

8. Strahlungsdetektionsvorrichtung (100; 1000), mit:
einem Substrat (110) mit mehreren Pixelelektroden (PE), die darauf angeordnet sind;
einer Gegenelektrode (CE), die den mehreren Pixelelektroden zugewandt ist;
einer Fotoleiterschicht (130) zwischen den mehreren Pixelelektroden und der Gegenelektrode, wobei die Fotoleiterschicht ausgebildet ist, elektrische Ladung in Reaktion auf einfallende Strahlung zu erzeugen;
mehreren Kondensatoren, die entsprechend mit einer jeweiligen der mehreren Pixelelektroden verbunden sind;
mehreren Transistoren, die zum selektiven Entladen der mehreren Kondensatoren ausgebildet sind;
einer Ausleseschaltungseinheit (1500), die mit den mehreren Transistoren verbunden ist;
einer Spannungsquelle (150; 1300), die ausgebildet ist, eine variable Spannung an die Gegenelektrode anzulegen; und
einer Steuereinheit (1400), die ausgebildet ist
während eines Bereitschaftsschritts die Spannungsquelle anzuweisen, eine erste Spannung an die Zellelektrode anzulegen, während keine Strahlung auf die Fotoleiterschicht auftrifft und eine Gatespannung nicht an ein Gate eines Transistors jeder Pixelelektrode angelegt ist;
während eines Rücksetzschritts die Spannungsquelle anzuweisen, eine zweite Spannung an die Zellelektrode anzulegen, während keine Strahlung auf die Fotoleiterschicht auftrifft und die Gatespannung an das Gate des Transistors jeder Pixelelektrode angelegt ist, wobei die zweite Spannung einen Absolutwert hat, der größer ist als derjenige der ersten Spannung;
während eines Bestrahlungsschritts die Spannungsquelle anzuweisen, die zweite Spannung an die Gegenelektrode anzulegen, während Strahlung auf die Fotoleiterschicht auftrifft und die Gatespannung nicht an das Gate des Transistors jeder Pixelelektrode angelegt ist; und
während eines Abtastschritts die Spannungsquelle anzuweisen, die erste Spannung an die Gegenelektrode anzulegen, während keine Strahlung auf die Fotoleiterschicht auftrifft und eine Gatespannung sequenziell an die Gates der mehreren Transistoren angelegt wird.

9. Strahlungsdetektionsvorrichtung nach Anspruch 8, wobei die Steuerung ausgebildet ist, die erste Spannung auf 0 V oder eine bezugspunktfreie Spannung festzulegen.

10. Strahlungsdetektionsvorrichtung nach Anspruch 8 oder 9, wobei die Steuerung ausgebildet ist, einen Wert der ersten Spannung derart festzulegen, dass die mehreren Pixelelektroden und die Gegenelektrode gleiche elektrische Potenziale haben.

11. Strahlungsdetektionsvorrichtung nach Anspruch 8, wobei die Steuerung ausgebildet ist, die erste Spannung so festzulegen, dass sie gleich einer gemeinsamen Referenzspannung der Ausleseschaltungseinheit ist.

12. Strahlungsdetektionsvorrichtung nach einem der Ansprüchen 8 bis 11, wobei die Fotoleiterschicht aufweist:
ein fotoleitendes Material mit HgI₂, HgO, PbI₂, CdTe, CdZnTe, PbO, PbO₂, CdS oder BiI₃.

13. Strahlungsdetektionsvorrichtung nach einem der Ansprüche 8 bis 12, wobei die Steuerung ausgebildet ist, einen Absolutwert der zweiten Spannung auf 300 V oder weniger festzulegen.

14. Strahlungsbildgebungsvorrichtung, mit:
einem Strahlungsgenerator (1100), der ausgebildet ist, Strahlung auf ein Objekt (OBJ) abzustrahlen; und
einer Strahlungsdetektionsvorrichtung nach einem der Ansprüche 8 bis 13.

## Revendications

1. Procédé de pilotage d'un appareil de détection de rayonnement, l'appareil de détection de rayonnement comprenant une pluralité d'électrodes de pixel, une contre-électrode faisant face à la pluralité d'électrodes de pixel, une couche photoconductrice entre la pluralité d'électrodes de pixel et la contre-électrode, une pluralité de condensateurs connectés à des électrodes de pixel respectives parmi la pluralité d'électrodes de pixel, et une pluralité de transistors configurés pour décharger sélectivement la pluralité de condensateurs, le procédé comprenant les opérations ultérieures suivantes dans l'ordre donné :
une opération d'attente au cours de laquelle une première tension est appliquée à la contre-électrode alors qu'aucun rayonnement n'est irradié vers la couche photoconductrice et qu'une tension de grille n'est pas appliquée à une grille du transistor de chaque électrode de pixel ;
une opération de réinitialisation au cours de laquelle une seconde tension est appliquée à la contre-électrode alors qu'aucun rayonnement n'est irradié vers la couche photoconductrice et que la tension de grille est appliquée à la grille du transistor de chaque électrode de pixel, la seconde tension ayant une valeur absolue supérieure à la première tension ;
une opération d'irradiation au cours de laquelle la seconde tension est appliquée à la contre-électrode alors qu'un rayonnement irradie la couche photoconductrice et que la tension de grille n'est pas appliquée à la grille du transistor de chaque électrode de pixel ; et
une opération de balayage au cours de laquelle la première tension est appliquée à la contre-électrode alors qu'aucun rayonnement n'est irradié vers la couche photoconductrice et qu'une tension de grille est appliquée séquentiellement aux grilles de la pluralité de transistors.

2. Procédé selon la revendication 1, dans lequel la première tension est de 0 V ou une tension flottante.

3. Procédé selon la revendication 1 ou 2, dans lequel la pluralité d'électrodes de pixels et la contre-électrode ont un potentiel électrique équivalent du fait d'une valeur de la première tension appliquée à la contre-électrode.

4. Procédé selon la revendication 1, dans lequel l'appareil de détection de rayonnement comprend en outre :
une unité de circuit de lecture connectée à la pluralité d'électrodes de pixels, et dans lequel
la première tension est équivalente à une tension commune de référence de l'unité de circuit de lecture.

5. Procédé selon l'une quelconque des revendications 1 à 4, dans lequel une valeur absolue de la seconde tension est de 300 V ou moins.

6. Procédé selon l'une quelconque des revendications 1 à 5, dans lequel le dispositif de détection de rayonnement comprend en outre un condensateur connecté à chacune de la pluralité d'électrodes de pixel, et le procédé comprend en outre de : décharger une charge électrique stockée dans un condensateur après l'opération d'attente et avant l'opération d'irradiation.

7. Procédé selon la revendication 6, comprenant en outre de :
collecter, au cours de l'opération d'irradiation, des charges électriques générées par le rayonnement irradié sur la couche photoconductrice dans le condensateur connecté à chacune de la pluralité d'électrodes de pixel, et
décharger séquentiellement le condensateur de sorte que les charges électriques stockées dans le condensateur sont lues par l'unité de circuit de lecture.

8. Appareil de détection de rayonnement (100 ; 1000) comprenant :
un substrat (110) sur lequel sont disposées une pluralité d'électrodes de pixel (PE) ; une contre-électrode (CE) faisant face à la pluralité d'électrodes de pixel ;
une couche photoconductrice (130) située entre la pluralité d'électrodes de pixel et la contre-électrode, la couche photoconductrice étant configurée pour générer une charge électrique en réponse à un rayonnement irradié sur celle-ci ;
une pluralité de condensateurs connectés à des électrodes de pixel respectives de la pluralité d'électrodes de pixel ;
une pluralité de transistors configurés pour décharger sélectivement la pluralité de condensateurs ;
une unité de circuit de lecture (1500) connectée à la pluralité de transistors ;
une source de tension (150 ; 1300) configurée pour appliquer une tension variable à la contre-électrode ; et
une unité de commande (1400) configurée pour
ordonner à la source de tension d'appliquer, au cours d'une opération d'attente, une première tension à la contre-électrode alors qu'aucun rayonnement n'est irradié vers la couche photoconductrice et qu'une tension de grille n'est pas appliquée à la grille d'un transistor de chaque électrode de pixel ;
ordonner à la source de tension d'appliquer, au cours d'une opération de réinitialisation, une seconde tension à la contre-électrode alors qu'aucun rayonnement n'est irradié vers la couche photoconductrice et que la tension de grille est appliquée à la grille du transistor de chaque électrode de pixel, la seconde tension ayant un valeur absolue supérieure à la première tension ;
ordonner à la source de tension d'appliquer, au cours d'une opération d'irradiation, la seconde tension à la contre-électrode alors que le rayonnement irradie la couche photoconductrice et que la tension de grille n'est pas appliquée à la grille du transistor de chaque électrode de pixel ; et
ordonner à la source de tension d'appliquer, pendant une opération de balayage, la première tension à la contre-électrode alors qu'aucun rayonnement n'est irradié vers la couche photoconductrice et qu'une tension de grille est appliquée séquentiellement aux grilles de la pluralité de transistors.

9. Appareil de détection de rayonnement selon la revendication 8, dans lequel le dispositif de commande est configuré pour établir la première tension à 0 V ou une tension flottante.

10. Appareil de détection de rayonnement selon la revendication 8 ou 9, dans lequel le dispositif de commande est configuré pour établir une valeur de la première tension de sorte que la pluralité d'électrodes de pixel et la contre-électrode ont des potentiels électriques équivalents.

11. Appareil de détection de rayonnement selon la revendication 8, dans lequel le dispositif de commande est configuré pour établir la première tension afin qu'elle soit équivalente à une tension commune de référence de l'unité de circuit de lecture.

12. Appareil de détection de rayonnement selon l'une quelconque des revendications 8 à 11, dans lequel la couche photoconductrice comprend :
un matériau photoconducteur comprenant l'un parmi HgI₂, HgO, PbI₂, CdTe, CdZnTe, PbO, PbO₂, CdS et BiI₃.

13. Appareil de détection de rayonnement selon l'une quelconque des revendications 8 à 12, dans lequel le dispositif de commande est configuré pour établir une valeur absolue de la seconde tension à 300 V ou moins.

14. Appareil d'imagerie par rayonnement comprenant :
un générateur de rayonnement (1100) configuré pour irradier un rayonnement sur un objet (OBJ) ;
un appareil de détection de rayonnement selon l'une quelconque des revendications 8 à 13.
